# EUROPÄISCHE PATENTSCHRIFT

(11) **EP 2 780 730 B1**
(45) Veröffentlichungstag und Bekanntmachung des Hinweises auf die Patenterteilung: **03.02.2016**
(21) Anmeldenummer: 12797773.4
(22) Anmeldetag: 15.11.2012
(51) Int. Cl.: G01R 31/28, G01R 31/327

(54) **INTEGRIERTE SCHALTUNG ZUM SCHALTEN VON LASTEN, SCHALTUNGSANORDNUNG MIT EINER INTEGRIERTEN SCHALTUNG UND EINER ANGESCHLOSSENEN LAST UND VERFAHREN ZUM BETREIBEN EINER SOLCHEN SCHALTUNGSANORDNUNG**
INTEGRATED CIRCUIT FOR SWITCHING LOADS, CIRCUIT ARRANGEMENT COMPRISING AN INTEGRATED CIRCUIT AND A CONNECTED LOAD, AND METHOD FOR OPERATING SUCH A CIRCUIT ARRANGEMENT
CIRCUIT INTÉGRÉ PERMETTANT DE COMMUTER DES CHARGES, CIRCUITERIE COMPORTANT UN CIRCUIT INTÉGRÉ ET UNE CHARGE CONNECTÉE, ET PROCÉDÉ PERMETTANT DE FAIRE FONCTIONNER UNE TELLE CIRCUITERIE

(30) Priorität: 18.11.2011 DE 102011086626
(43) Veröffentlichungstag der Anmeldung: 24.09.2014
(73) Patentinhaber: Continental Automotive GmbH, 30165 Hannover (DE)
(72) Erfinder: SCHMAUSS, Harald, 93093 Donaustauf (DE); MURESAN, Sergiu, R-400655 Cluj-Napoca (RO); WOLFARTH, Gunther, 93055 Regensburg-Harting (DE); WELL, Marco, 35398 Giessen (DE); FALTER, Johann, 93173 Wenzenbach (DE); LABERER, Franz, 93059 Regensburg (DE); THEIL, Cristian, R-300371 Timisoara (RO)
(86) Internationale Anmeldenummer: PCT/EP2012/072718
(87) Internationale Veröffentlichungsnummer: WO 2013/072411

(56) Entgegenhaltungen:
- DE-A1-102006 045 308
- DE-B3-102004 054 374
- US-A1- 2010 134 091
- US-A1- 2011 058 296

## Beschreibung

In den meisten elektrischen oder elektronischen Geräten müssen Lasten ein- oder ausgeschaltet werden. Als Schalter werden neben Relais oder sonstigen mechanischen Schaltern häufig elektronische Leistungstransistoren, meist in integrierter Form, verwendet. Insbesondere in Fahrzeugen gibt es eine Fülle von Lasten, die häufig ein- und ausgeschaltet werden müssen, oft sogar viele Male pro Sekunde. Beispiele für derartige Lasten sind Solenoide für Einspritzventile, Starkstromrelais, Motoren und viele Arten von Signalleuchten in Form von Lampen oder Leuchtdioden.

Die DE 10 2006 045 308 A1 beschreibt eine Schaltungsanordnung mit einer integrierten Schaltung, die ein Schaltelement enthält, mittels dem eine an die integrierte Schaltung anschließbare Last ein- und ausgeschaltet werden kann. Die in integrierten Schaltungen integrierten Schaltelemente werden häufig als sogenannte Low-Side-Schalter ausgeführt, bei denen ein Schaltanschluss auf ein vorgegebenes niedriges Potential meist mittels eines Leistungstransistors schaltbar ist. Dies dient dazu, eine an den Schaltanschluss angeschlossene Last, beispielsweise ein Schaltrelais, das besonders hohe Ströme oder Spannungen schalten muss, anzusteuern. Ein solcher Low-Side-Schalter verbindet eine an einem Betriebsspannungspotential liegende Last mit Masse. Bei High-Side-Schaltern lässt sich der jeweilige Schaltanschluss einer Last über einen Schalttransistor mit einem vorgegebenen hohen Potential verbinden, um die jeweilige an Masse liegende Last mit Energie zu versorgen. Grundsätzlich ist es auch möglich, in der integrierten Schaltung sowohl einen High-Side- als auch einen Low-Side-Schalter mit einem Ausgang zu verbinden, so dass eine daran angeschlossene Last sowohl mit dem positiven Versorgungspotential, als auch mit Masse verbunden werden kann, je nachdem, welcher Transistors angesteuert wird. Außerdem können durch entsprechende Wahl und Verknüpfung mehrerer Ausgänge einer solchen integrierten Schaltung auch H-Brücken beispielsweise zur Ansteuerung eines Motors als Last gebildet werden.

Neben der Energieversorgung einer Last durch die Ansteuerung des Schaltanschlusses des jeweiligen Schaltelements ist es auch wünschenswert, mögliche Fehlerzustände des Schaltelements, der Last selbst oder der Leitungen zu erkennen. Übliche Fehler sind dabei Kurzschlüsse von Anschlüssen des Schaltelements oder der Last gegenüber Masse und der positiven Versorgungsspannung oder eine Unterbrechung der Leitung beispielsweise zwischen dem Schaltelement und der Last. Um diese Fehlermöglichkeiten zu erkennen, sind Verfahren bekannt, bei denen im abgeschalteten Zustand des jeweiligen Schaltelements ein Referenzpotential an einen jeweiligen Anschluss angelegt wird und der zeitliche Spannungsverlauf gemessen wird. Aber auch im eingeschalteten Zustand des Schaltelements kann anhand von Spannungspotentialen aber auch von Spannungsverläufen sowie der Verhältnisse verschiedener Spannungen und Ströme zueinander auf Kurzschlüsse oder auch eine Leitungsunterbrechung geschlossen werden.

Die DE 10 2004 054 374 B3 beschreibt ein Diagnosekonzept zum Testen integrierter Schaltkreise mit Leistungstransistoren. Dabei sind in einem integrierten Schaltkreis meist mehrere als Leistungstransistoren ausgebildete Schaltelemente sowohl als Low-Side- oder High-Side- oder auch als Brückenschaltungen mit jeweiligen Ausgängen des integrierten Schaltkreises zum Anschließen einer Last vorgesehen.

Die US 2011/058296 A1 offenbart eine Schaltung zum Schalten von Lasten mit einer Mikroprozessorgesteuerten Überwachungseinheit.

Eine integrierte Schaltung mit Schaltelementen ist meist über einen standardisierten Bus - beispielsweise SPI Bus - von einem Mikroprozessor ansteuerbar. Über diese Schnittstelle können einerseits die Schaltkommandos übermittelt werden und andererseits auch die Testergebnisse an den Mikroprozessor gemeldet werden. Es ist wünschenswert, wenn die Tests in der integrierten Schaltung autark durchgeführt werden und lediglich die Er-gebnisse zur weiteren Verarbeitung beispielsweise an den Mikroprozessor gesendet werden.

Insbesondere bei Leuchtdioden als zu schaltender Last kann ein Test im eigentlich ausgeschalteten Zustand zu einem Stromfluss durch die Leuchtdiode führen, der zumindest zu einem kurzen Aufleuchten führt, was beispielsweise bei Anwendung in einem Armaturenbrett eines Fahrzeugs zu Irritationen des Fahrers führen kann.

Aufgabe der Erfindung ist es daher, dieses Problem zu vermeiden.

Die Aufgabe wird durch eine integrierte Schaltung gemäß Anspruch 1, eine Schaltungsanordnung gemäß Anspruch 3 und ein Verfahren gemäß Anspruch 5 gelöst. Vorteilhafte Weiterbildungen sind in den Unteransprüchen angegeben.

Gemäß der Erfindung weist eine integrierte Schaltung mit einem steuerbaren Schaltelement eine Testeinheit auf, mittels der verschiedene Tests zur Funktionsfähigkeit des Schaltelements und der Unversehrtheit der Leitungen durchgeführt werden können. Insbesondere sind Kurzschlüsse gegen Masse und Versorgungspotential und Leitungsbrüche detektierbar. Eine Steuereinheit steuert dabei die Testeinheit an, um die Art und den Zeitpunkt und Ablauf der Tests festzulegen. In erfindungsgemäßer Weise ist ein über einen Eingang der integrierten Schaltung beschreibbarer Speicher vorgesehen, dessen Inhalt von der Steuereinheit abfragbar ist und über den die Art und der Zeitpunkt jeweiliger Tests festgelegt werden kann.

So kann beispielsweise über eine entsprechende Information festgelegt werden, dass bei einer an den Ausgang der integrierten Schaltung als mittels des Schaltelements zu schaltende Last angeschlossenen Leuchtdiode während des Normalbetriebs keine Leitungsbruchdetektionstests durchgeführt werden, da diese Tests bei ausgeschaltetem Schaltelement einen Prüfstrom an die Leitung legt, um eine bei intakter Leitung erwartete Spannung abzufragen, der jedoch zu einem zumindest schwachen, jedoch störenden Leuchten der Leuchtdiode führen kann.

Durch die Erfindung kann also in einfacher Weise durch Einschreiben einer entsprechenden Information in den Speicher festgelegt werden, dass eine Leuchtdiode an den Ausgang angeschlossen ist und welche Tests daher zu welchen Zeitpunkten durchgeführt werden sollen. Dies kann durch die Wahl der Information für den Speicher für jede anzuschließende Last spezifisch und veränderbar festgelegt werden.

Die Erfindung soll nachfolgend anhand eines Ausführungsbeispiels mit Hilfe einer Figur näher erläutert werden. Dabei zeigt:

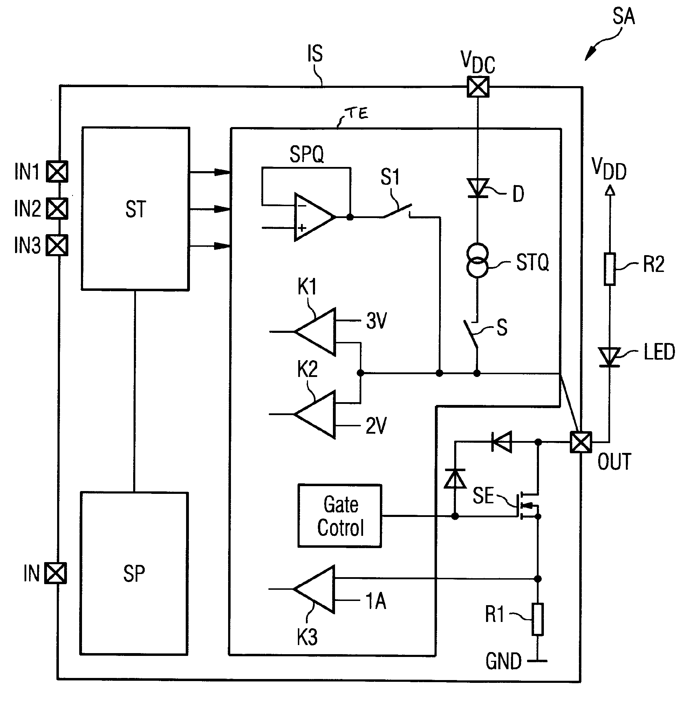

Figur 1 eine erfindungsgemäße Schaltungsanordnung.

Eine erfindungsgemäße Schaltungsanordnung SA gemäß der Figur 1 ist mit einer integrierten Schaltung IS gebildet, an deren Ausgang OUT eine Leuchtdiode LED über einen zweiten Widerstand R2 mit einem positiven Versorgungspotential V_{DD} angeschlossen ist. In der Figur 1 ist nur ein Ausgang OUT eingezeichnet, die integrierte Schaltung IS kann jedoch prinzipiell mit einer Vielzahl von weiteren Ausgängen ausgebildet sein.

Innerhalb der integrierten Schaltung IS ist der Ausgang OUT über die Schaltstrecke eines Schaltelements SE und einen ersten Widerstand R1 mit dem Massepotential GND verbunden. Das Schaltelement SE ist damit als sogenannter Low-Side-Schalter ausgebildet; an den weiteren Ausgängen können jedoch ebenso Schaltelemente als High-Sside-Schalter, die also den jeweiligen Ausgang über deren Laststrecke mit dem positiven Versorgungspotential verbinden, ausgebildet sein. In gleicher Weise ist es möglich, sowohl einen High-Side- als auch einen Low-Side-Schalter mit demselben Ausgang zu verbinden.

Das Schaltelement SE ist als n-Kanal MOSFET ausgebildet, bei dem zur Klemmung der beim Abschalten am Drainanschluss entstehenden Spannung der Drain- und der Gateanschluss über eine in Fluss- und eine in Sperrrichtung gepolte Diode miteinander verbunden sind. Der Gateanschluss des Schaltelements SE ist mit einer Gateansteuerschaltung GateControl verbunden.

Die integrierte Schaltung weist neben dem Schaltelement SE außerdem eine Testeinheit TE auf, in der eine Vielzahl an Spannungs- und/oder Stromquellen, Spannungs- und/oder Strom-Messvorrichtungen ausgebildet sein können. Als Beispiel ist eine Spannungsquelle SPQ, die als Spannungsfolger ausgebildet ist und einen Strom bestimmter Größe -beispielsweise im µA-Bereich - liefert, dargestellt. Diese Spannungsquelle SPQ kann über einen ersten Schalter S1 mit dem Ausgangsanschluss OUT verbunden werden.

Es ist außerdem ein Fensterkomparator, der mit zwei Komparatoren K1 und K2 gebildet ist, dargestellt. Als Fenstergrenzen sind zwei Spannungen mit den Werten 2V und 3V angegeben. Mittels der Spannungsquelle SPQ und dem Fensterkomparator K1, K2 kann beispielsweise festgestellt werden, ob bei Anlegen der Spannung der Spannungsquelle SPQ über den Schalter S1 an den Ausgangsanschluss OUT eine Sollspannung zwischen 2 und 3 V gemessen werden kann. Ist dies nicht der Fall, kann je nach dem, welche der Sollschwellen unter- oder überschritten ist, auf einen Fehlerfall geschlossen werden.

Die Testeinheit TE soll als Beispiel außerdem einen dritten Komparator K3 aufweisen, dessen einer Eingang mit dem Verbindungsanschluss zwischen dem Schaltelement SE und dem ersten Widerstand R1 verbunden ist, um mittels des Spannungsabfalls am ersten Widerstand R1 den Strom durch das Schaltelement SE bestimmen zu können. Über eine Teilschaltung Gatecontrol der Testeinheit TE kann zu Testzwecken das Schaltelement SE ein- oder ausgeschaltet werden. Die Testeinheit TE enthält außerdem zwischen einem Anschluss für das erste Versorgungspotential V_{DD} und dem Ausgang OUT in Serie geschaltet eine Diode D, eine Stromquelle STQ und einen zweiten Schalter S2. Hierdurch kann ein Teststrom an die mit dem Ausgang OUT der integrierten Schaltung IS verbundenen Leitungen gelegt werden. Mittels der dargestellten Testschaltungen innerhalb der Testeinheit TE kann durch entsprechende Auswertung der gemessenen Spannungen und Ströme ermittelt werden, ob beispielsweise ein Kurzschluss gegen Masse oder das Versorgungspotential des Drain- oder des Sourceanschlusses des als MOSFET ausgebildeten Schaltelements SE oder eine Leitungsunterbrechung am Ausgang OUT vorliegen.

Die Ansteuerung der Testeinheit TE erfolgt über eine Steuerung, die ihrerseits über eine nicht dargestellte Schnittstelle über einen externen Mikroprozessor angesteuert werden kann. Mittels der Steuereinheit ST kann festgelegt werden, in welcher Reihenfolge zu welchen Zeiten welche Spannungen und welche Ströme an die Anschlüsse des Schaltelements SE angelegt werden können und in welcher Art und Weise diese ausgewertet werden. Wird beispielsweise bei ausgeschaltetem Schaltelement SE über die Spannungsquelle SPQ eine Spannung an den Ausgang OUT gelegt, so würde bei intakter Leitung aus dem ersten Versorgungspotential V_{DD} ein Strom durch die Leuchtdiode LED fließen, was trotz ausgeschaltetem Element SE zu einem zumindest schwachen Aufleuchten der Leuchtdiode LED führen könnte. Dies kann bei bestimmten Anwendungen insbesondere in einem Armaturenbrett eines Kraftfahrzeugs störend sein, da ein Fahrer hierdurch irritiert sein könnte.

In erfindungsgemäßer Weise ist deshalb in der integrierten Schaltung ein Speicher SP vorgesehen, der mit der Steuereinheit ST verbunden ist und in den über einen Eingang IN der integrierten Schaltung IS eine Information, die beispielsweise von einem Mikroprozessor kommt, eingeschrieben werden kann. Diese Information beinhaltet, welche Art von Last - beispielsweise eine Leuchtdiode LED - an den Ausgang OUT der integrierten Schaltung IS angeschlossen ist und welche Tests in welcher Abfolge bzw. zu welchen Zeitpunkten entsprechend durchgeführt werden sollen. So ist es aufgrund der für eine angeschlossene Leuchtdiode LED beschriebenen Problems möglich und sinnvoll, aufgrund der in den Speicher SP eingeschriebenen Information die Steuereinheit ST zu veranlassen, die Testeinheit TE derart anzusteuern, dass ein Leitungsbruchtest nur durchgeführt wird, wenn ein Leuchten der Leuchtdiode LED nicht stört, also beispielsweise beim Anlassen eines Fahrzeugs, wenn also alle Warnleuchten am Fahrzeugs aufgrund eines Testbetriebs aufleuchten. Alle anderen Tests können standardmäßig durchgeführt werden.

Die Information im Speicher SP kann entweder fest eingeschrieben werden oder aber bei jeder Inbetriebnahme durch den Mikroprozessor neu eingeschrieben werden. Auf diese Weise ist es möglich, Anpassungen vorzunehmen, insbesondere die Verwendung des oder der Ausgänge für verschiedene Lasten variabel zu gestalten.

Die integrierte Schaltung IS weist des Weiteren eine Anzahl weiterer Eingänge IN1 bis INn auf, über die beispielsweise die Steuereinheit ST von außen angesteuert werden kann oder auch der Steueranschluss des Schaltelements SE, im dargestellten Beispiel der Gateanschluss des n-Kanal MOSFETs, von außen, beispielsweise vom Mikroprozessor entsprechend angesteuert werden kann, um die Last zu betreiben.

## Patentansprüche

1. Integrierte Schaltung (IS) mit
- einem steuerbaren Schaltelement (SE), dessen Laststrecke zwischen einem Ausgang (OUT) der integrierten Schaltung (IS) und einem Versorgungspotential angeordnet ist,
- einer Testeinheit (TE), die mit den Anschlüssen des Schaltelements (SE) zur Durchführung von Tests verbunden ist, einer Steuereinheit (ST), die über zumindest eine Steuerleitung mit der Testeinheit (TE) verbunden ist, wobei die Abfolge der Tests abhängig von Signalen auf der/den Steuerleitung(en) erfolgt, und **gekennzeichnet dadurch, dass**
die Integrierte Schaltung enthält
- einen Speicher (SP), der mit der Steuereinheit (ST) verbunden ist und durch dessen Inhalt die Art und der Zeitpunkt der Tests festgelegt ist, wobei der Speicher (SP) mit einem Eingang (IN) der integrierten Schaltung (IS) zur Eingabe des Inhalts verbunden ist.

2. Integrierte Schaltung nach Anspruch 1, **dadurch gekennzeichnet, dass** das Versorgungspotential ein Massepotential (GND) ist.

3. Schaltungsanordnung (SA) mit einer integrierten Schaltung (IS) nach Anspruch 1 oder 2, und mit einer an den Ausgang (OUT) der integrierten Schaltung (IS) angeschlossenen Last (LED), wobei der Inhalt des Speichers (SP) abhängig von der Art der Last (LED) ist.

4. Schaltungsanordnung (SA) nach Anspruch 3, **dadurch gekennzeichnet, dass** die Last eine Leuchtdiode (LED) ist.

5. Verfahren zum Betreiben einer Schaltungsanordnung (SA) nach einem der Ansprüche 3 oder 4, mit den Schritten:
- Eingeben einer Information über die Art der Last (LED) über den Eingang (IN) der integrierten Schaltung (IS) in den Speicher (SPQ),
- Auslesen der Information im Speicher (SP) durch die Steuereinheit (ST) und Ansteuerung der Testeinheit (TE) durch die Steuereinheit (ST) in Abhängigkeit von der Information,
- Testen des Schaltelements (SE) durch die Testeinheit (TE), wobei die Art und der Zeitpunkt des Tests durch die Ansteuerung durch die Steuereinheit (ST) bestimmt ist.

6. Verfahren nach Anspruch 5, **dadurch gekennzeichnet, dass** die Information bei jedem Einschalten der integrierten Schaltung (IS) in den Speicher (SP) insbesondere durch einen Mikroprozessor eingegeben wird.

7. Verfahren nach Anspruch 5 oder 6, **dadurch gekennzeichnet, dass** durch die Information bestimmt wird, dass mit einer Leuchtdiode (LED) als Last ein Leitungsbruchtest nur während Zeiten durchgeführt wird, bei denen ein hierdurch auftretendes Leuchten der Leuchtdiode (LED) unkritisch ist.

## Claims

1. Integrated circuit (IS) comprising
- a controllable switching element (SE), whose load path is arranged between an output (OUT) of the integrated circuit (IS) and a supply potential,
- a test unit (TE), which is connected to the connections of the switching element (SE) for performing tests,
- a control unit (ST), which is connected to the test unit (TE) via at least one control line, wherein the series of tests is performed depending on signals on the control line(s), **characterized in that** the integrated circuit contains
- a memory (SP), which is connected to the control unit (ST) and whose content is used to determine the nature and time of the tests, wherein the memory (SP) is connected to an input (IN) of the integrated circuit (IS) for inputting the content.

2. Integrated circuit according to Claim 1, **characterized in that** the supply potential is a ground potential (GND).

3. Circuit arrangement (SA) comprising an integrated circuit (IS) according to Claim 1 or 2 and comprising a load (LED) connected to the output (OUT) of the integrated circuit (IS), wherein the content of the memory (SP) is dependent on the type of load (LED).

4. Circuit arrangement (SA) according to Claim 3, **characterized in that** the load is a light-emitting diode (LED).

5. Method for operating a circuit arrangement (SA) according to either of Claims 3 and 4, comprising the following steps:
- inputting information relating to the type of load (LED) via the input (IN) of the integrated circuit (IS) into the memory (SP),
- reading the information in the memory (SP) by means of the control unit (ST) and actuating the test unit (TE) by means of the control unit (ST) depending on the information,
- testing the switching element (SE) by means of the test unit (TE), wherein the type and time of the test is determined by the actuation by the control unit (ST).

6. Method according to Claim 5, **characterized in that** the information is input into the memory (SP), in particular by means of a microprocessor, each time the integrated circuit (IS) is switched on.

7. Method according to Claim 5 or 6, **characterized in that** the information is used to determine that a line breakage test is performed, with a light-emitting diode (LED) as load, only during times at which a resultant illumination of the light-emitting diode (LED) is not critical.

## Revendications

1. Circuit intégré (IS) comprenant :
- un élément de commutation pouvant être commandé (SE) dont la section de charge est agencée entre une sortie (OUT) du circuit intégré (IS) et un potentiel d'alimentation,
- une unité de test (TE) qui est reliée aux bornes de l'élément de commutation (SE) aux fins de la réalisation de tests, une unité de commande (ST) qui est reliée à l'unité de test (TE) par le biais d'au moins un fil de commande, la succession des tests se déroulant en fonction de signaux présents sur la/les ligne(s) de commande,
**caractérisé en ce que** le circuit intégré comprend une mémoire (SP) qui est reliée à l'unité de commande (ST) et au moyen du contenu de laquelle le type et le moment des tests sont déterminés, la mémoire (SP) étant reliée à une entrée (IN) du circuit intégré (IS) aux fins de l'introduction du contenu.

2. Circuit intégré selon la revendication 1, **caractérisé en ce que** le potentiel d'alimentation est un potentiel de masse (GND).

3. Agencement de circuit (SA) comprenant un circuit intégré (IS) selon la revendication 1 ou 2, et comprenant une charge (LED) raccordée à la sortie (OUT) du circuit intégré (IS), le contenu de la mémoire (SP) dépendant du type de la charge (LED).

4. Agencement de circuit (SA) selon la revendication 3, **caractérisé en ce que** la charge est une diode électroluminescente (LED).

5. Procédé destiné à faire fonctionner un agencement de circuit (SA) selon l'une des revendications 3 ou 4, comprenant les étapes consistant à :
- entrer une information sur le type de la charge (LED) dans la mémoire (SP) par le biais de l'entrée (IN) du circuit intégré (IS),
- lire l'information présente dans la mémoire (SP) au moyen de l'unité de commande (ST) et commander l'unité de test (TE) en fonction de l'information au moyen de l'unité de commande (ST),
- tester l'élément de commutation (SE) au moyen de l'unité de test (TE), le type et le moment du test étant déterminés au moyen de la commande par l'unité de commande (ST).

6. Procédé selon la revendication 5, **caractérisé en ce que** l'information est entrée dans la mémoire (SP) à chaque activation du circuit intégré (IS), en particulier au moyen d'un microprocesseur.

7. Procédé selon la revendication 5 ou 6, **caractérisé en ce qu'**il est déterminé au moyen de l'information qu'avec une diode électroluminescente (LED) comme charge, un test de rupture de ligne est uniquement réalisé à des moments pendant lesquels un allumage de la diode électroluminescente (LED) provoqué par cette opération n'est pas critique.
